# FASCICULE DE BREVET EUROPEEN

(11) **EP 0 402 276 B1**
(45) Date de publication et mention de la délivrance du brevet: **17.03.1993**
(21) Numéro de dépôt: 90420242.1
(22) Date de dépôt: 18.05.1990
(51) Int. Cl.: H05K 7/18

(54) **Armoire étanche d'appareillage électrique**
Abgedichteter Schaltschrank
Sealed cabinet for electrical apparatus

(30) Priorité: 05.06.1989 FR 8907506
(43) Date de publication de la demande: 12.12.1990
(73) Titulaire: MERLIN GERIN, F-38240 Meylan (FR)
(72) Inventeur: Carle, Pierre, F-38050 Grenoble Cedex (FR); Betsch, Fréderic, F-38050 Grenoble Cedex (FR); Goutay, Roland, F-38050 Grenoble Cedex (FR); Xaus, Luis, F-38050 Grenoble Cedex (FR)
(74) Mandataire: Ritzenthaler, Jacques

(56) Documents cités:
- EP-A- 0 281 983
- DE-U- 8 335 383

## Description

L'invention est relative à une armoire d'appareillage électrique ou électronique ayant des parois formées par des panneaux ou plaques fixés sur des éléments allongés disposés aux angles de l'armoire et assemblés à leurs extrémités pour constituer une ossature de support, l'ensemble desdits éléments angulaires étant constitués par des profilés tubulaires identiques disposés de la même manière et ayant deux faces orthogonales, orientées vers l'intérieur de l'armoire et munies de rangées de perforations pour la fixation de traverses de support de l'appareillage logé à l'intérieur de l'armoire, dont la continuité de l'étanchéité au niveau des jonctions angulaires des panneaux est assurée par le profilé correspondant, auquel sont accolés les bords espacés des panneaux avec interposition d'un joint d'étanchéité.

Une telle armoire est connue par exemple du DE-U-83 35 383. Le profilé selon le DE-U-8335 383 a une section carrée comportant deux branches, dont une est le prolongement d'une des faces du profilé munies de perforations et l'autre est le prolongement de l'autre des faces du profilé munies de perforations, mais avec une partie finale pliée à angle droit.

Les impératifs de standardisation et de fabrication en série imposent une utilisation d'un nombre limité d'éléments permettant la réalisation d'armoires de taille différente et répondant aux besoins de fixation de l'appareillage et de juxtaposition dans les tableaux électriques. L'armoire est constituée d'une ossature ou charpente réalisée par un assemblage de profilés standards et par des panneaux généralement en tôle fixés sur cette ossature. La taille de ces armoires est souvent importante de quelques mètres de hauteur, et les joints élastiques d'étanchéité insérés entre les éléments au niveau de leur assemblage sont souvent insuffisants pour palier les imperfections d'usinage ou les déformations locales intervenant lors du montage. Il a déjà été proposé de séparer les fonctions de support et les fonctions d'étanchéité assurées par les profilés constituant l'ossature, en ménageant sur le profilé des extensions qui coopèrent avec les joints. Ces profilés sont de formes compliquées et souvent dissymétriques, ce qui complique le montage et peut être à l'origine d'assemblage incorrect.

La présente invention a pour but de permettre la réalisation d'une armoire utilisant un profilé standard assurant à la fois la fonction de support et une étanchéité améliorée au droit des jonctions.

Le profilé de l'armoire selon la présente invention est constitué par une cornière dont les deux côtés sont disposés à l'intérieur de l'armoire pour former lesdites deux faces orthogonales de fixation, le bord longitudinal de chaque côté, opposé à l'arête de la cornière, étant replié en équerre vers l'intérieur suivant un contour tronqué, contre lequel repli est accolé le bord du panneau conjugué et le profilé présentant une cloison extérieure reliant lesdits bords de la cornière et assurant l'étanchéité de la jonction angulaire en formant un prisme dont la base est un triangle rectangle isocèle, le profilé ayant un plan de symétrie correspondant au plan bissecteur de la cornière.

La cloison externe en diagonale délimite la zone étanche interne à l'armoire de la zone extérieure non étanche. Les panneaux sont appliqués contre les bords externes du profilé avec interposition d'un joint d'étanchéité, avantageusement constitué par un bourrelet élastique intercalé entre le panneau et le bord du profilé. Le repli en équerre du bord du profilé s'étend parallèlement au panneau adjacent à faible distance de ce dernier et constitue un écran de protection du joint, notamment contre les projections d'eau venant de l'extérieur. Les panneaux présentent des bords rabattus qui coiffent les replis du profilé de manière à constituer une protection additionnelle en présentant un véritable labyrinthe d'accès au joint. Les bords rabattus des panneaux contribuent bien entendu à leur rigidité et à l'esthétique de l'armoire. Le rôle d'écran des replis des profilés est particulièrement utile lorsque ces profilés sont disposés en traverses supérieures. L'eau ruisselant du toit est alors recueillie par la gouttière constituée par le repli. Ce rôle de gouttière est indispensable lorsque le panneau adjacent est agencé en porte, de façon à éviter lors de l'ouverture de la porte un écoulement de l'eau accumulé vers l'intérieur de l'armoire. Dans cette disposition il est avantageux de reporter le joint vers l'extrémité du repli pour empêcher la formation d'une rigole d'accumulation d'eau entre le panneau et le repli du profilé.

Les panneaux peuvent être fixés par tout moyen approprié directement sur les profilés ou sur les replis de ces derniers, un mode de fixation préférentiel faisant usage d'une pièce intermédiaire, elle-même accolée et fixée à la cloison diagonale. Cette pièce intermédiaire est commune aux deux panneaux angulaires, qui sont fixés par de simples vis s'engageant dans des taraudages de la pièce intermédiaire. Cette pièce intermédiaire peut être agencée, ou porter la charnière d'un panneau mobile constituant une porte. Les profilés sont assemblés les uns aux autres par des pièces d'angle en forme de tripode. Ces pièces d'angle disposées aux huit coins de l'armoire sont tout comme les profilés, des pièces identiques symétriques évitant toute erreur de montage. L'ensemble est particulièrement simple et assure une facilité de montage alliée à une modularité et à une rigidité optimale. Plusieurs ossatures peuvent être accolées et solidarisées les unes aux autres pour constituer des armoires de tailles multiples, le panneau intermédiaire étant bien entendu supprimé de manière à accoler les profilés des deux ossatures adjacentes les uns contre les autres, avec interposition d'un joint d'étanchéité analogue à celui utilisé pour les panneaux. Le contour externe tronqué des profilés contribue à la rigidité de ces assemblages, lesquels comportent des boulons ou éclisses de liaison des profilés. De telles extensions sont réalisables sur toutes les faces de l'armoire tout en conservant une parfaite étanchéité et sans modification des panneaux constitutifs des parois.

Les profilés peuvent être partiellement emboîtés par paire, ce qui facilite le stockage et le transport.

D'autres avantages et caractéristiques ressortiront plus clairement de la description qui va suivre d'un mode de mise en oeuvre de l'invention donné à titre d'exemple non limitatif et représenté aux dessins annexés dans lesquels:

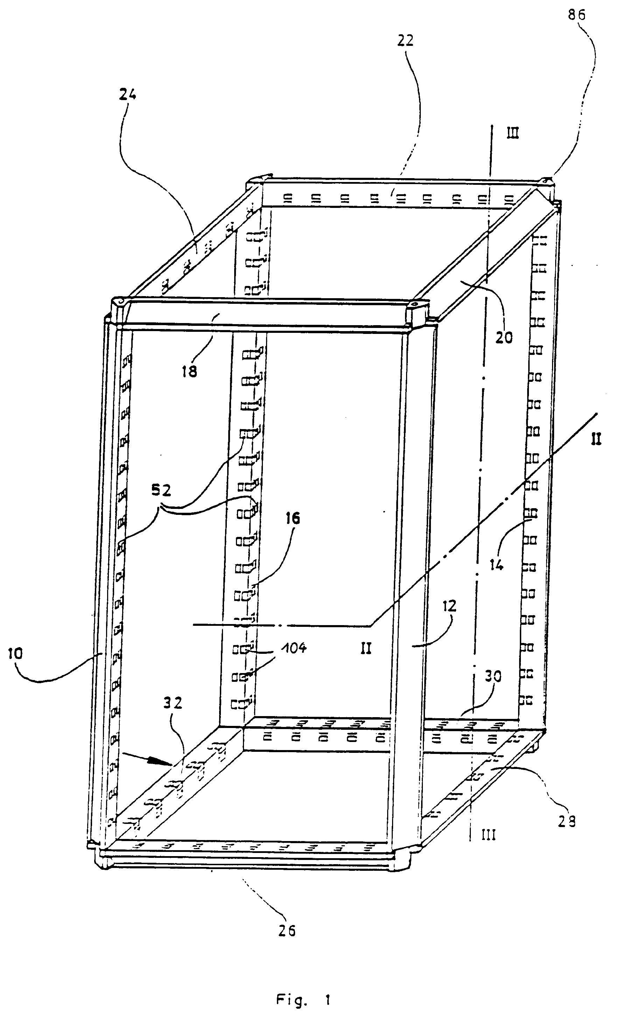

- la figure 1 est une vue schématique en perspective d'une ossature d'une armoire selon l'invention;
- la figure 2 est une coupe suivant la ligne II-II de la figure 1;
- la figure 3 est une coupe suivant la ligne III-III de la figure 1;,
- la figure 4 est une section du profilé constitutif de l'ossature selon la figure 1;
- la figure 5 est une vue analogue à celle de la figure 4, illustrant une variante de réalisation;
- la figure 6 illustre une autre variante de réalisation du profilé.

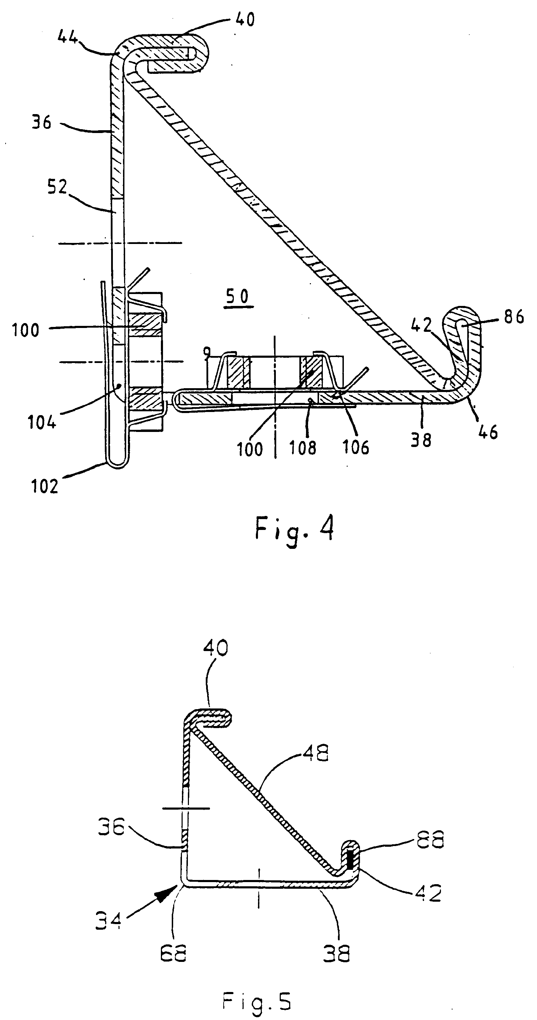

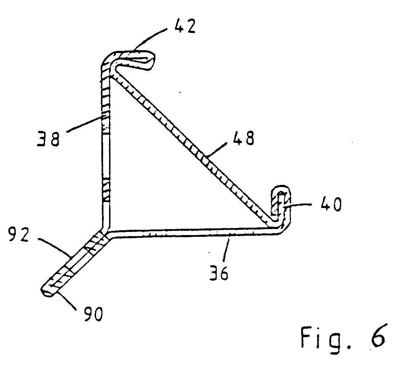

Sur les figures, une armoire de logement d'appareillage électrique est constituée par l'assemblage de 12 éléments angulaires formant un parallélépipède rectangle droit. Les profilés 10,12,14,16 formant les montants ou éléments angulaires verticaux ainsi que les profilés 18,20,22,24 de la partie supérieure de l'ossature, et les profilés 26,28,30,32 de la partie inférieure de l'ossature sont tous identiques et disposés de la même manière. En se référant plus particulièrement aux figures 4 et 5, on voit que les profilés 10 à 32 ont une partie en cornière 34 dont les deux côtés 36,38 sont orthogonaux et présentent des bords longitudinaux repliés en équerre pour obtenir un repli 40,42 dirigé vers l'intérieur. Les arêtes 44,46 constituées par les bords repliés 40,42 sont reliées par une cloison d'extérieur 48 confinant avec la cornière 34 un espace interne tubulaire 50 de section triangulaire. Les deux côtés 36,38 de la cornière 34 sont munis de rangées de perforations 52 pour la fixation de traverses 53 de support de l'appareillage électrique logé dans l'armoire d'une manière bien connue des spécialistes. Les traverses 53 sont fixées aux cornières 34 par des boulons dont les écrous sont insérés dans le profilé. La cloison extérieure 48 qui s'étend suivant l'hypoténuse du profilé triangulaire est une cloison pleine ou munie d'un nombre limité de perforations de fixation dont l'utilité sera décrite par la suite.

L'ossature de l'armoire est habillée de panneaux 54,56 respectivement sur la face arrière et sur la face avant de l'armoire ainsi que de panneaux 58,60 sur les faces latérales et 62,64 à la base et au sommet de l'armoire. Ces panneaux sont chacun constitués par une plaque de tôle dont les bords 66 sont rabattus à angle droit pour assurer la rigidité du panneau. Les profilés 10 à 32 sont tous disposés de la même manière avec l'arête 68 de la cornière 34, correspondant au sommet de l'angle droit du triangle rectangle, orientée vers l'intérieur de l'armoire. Les panneaux 54 à 64 coopèrent avec les arêtes 44 et 46 des bords repliés ou replis 40,42 avec interposition de joints d'étanchéité 70 en forme de bourrelet s'étendant sur le pourtour du panneau. Les panneaux 54 à 64 sont fixés aux profilés 10 à 32 par des vis 72 se vissant dans des pièces intermédiaires 74 accolées à la cloison externe 48. La fixation des pièces intermédiaires peut être réalisée par tout moyen approprié, par exemple par collage ou tout simplement par des boulons traversant des orifices ménagés dans la cloison 48. La même pièce intermédiaire 74 sert de fixation aux deux panneaux formant l'angle correspondant de l'armoire. Cette pièce intermédiaire s'inscrit dans le gabarit externe du profilé et présente une découpe 76 de logement des rebords 66 des panneaux 54 à 64. La fixation des panneaux 54 à 64 peut bien entendu être réalisée d'une manière différente, les vis 72 pouvant par exemple prendre appui sur les replis 40,42 ou directement sur la cloison 48.

Lorsque l'un des panneaux, notamment le panneau avant 56 est agencé en porte, la pièce intermédiaire correspondante 78 est conformée pour constituer une charnière 80 de support de la porte 56. La charnière 80 s'inscrit dans le gabarit externe du profilé. La pièce intermédiaire opposée, disposée du côté mobile de la porte 56 peut être identique aux autres, ou être dépourvue de l'un des points de fixation rendu inutile par la présence de la porte 56.

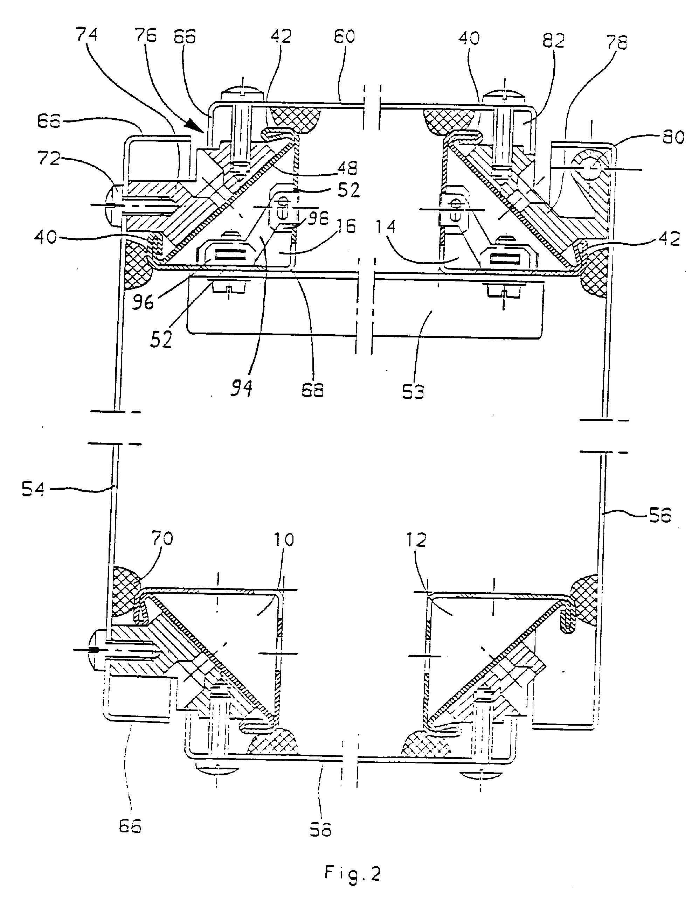

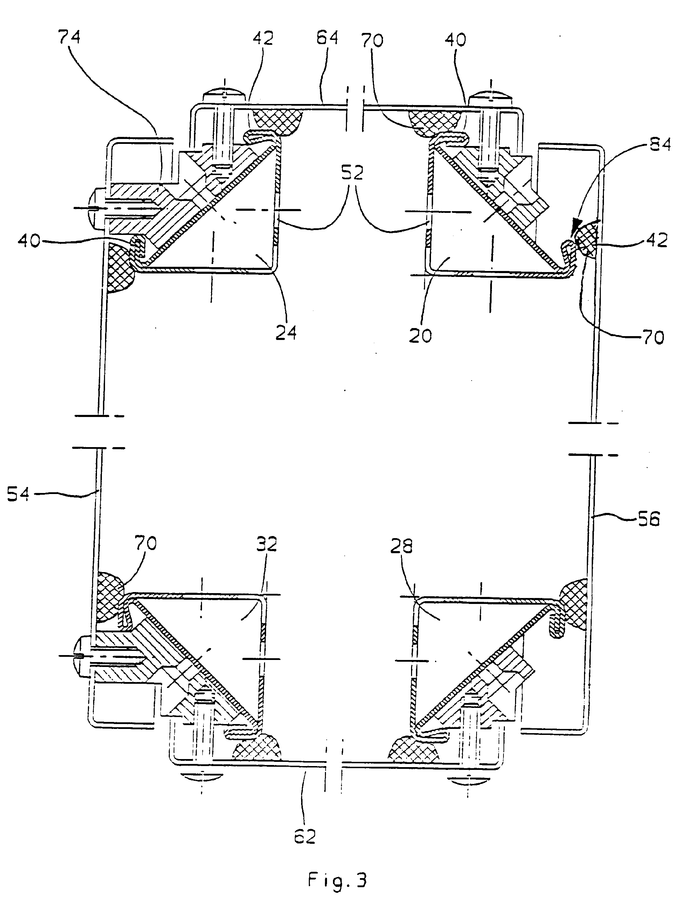

En se référant plus particulièrement à la figure 2, on voit que l'ensemble des joints 70 coopérant avec les profilés verticaux 10 à 16, coopèrent avec les arêtes 44,46, constituées par les bords repliés 40,42. L'étanchéité entre deux panneaux adjacents, par exemple les panneaux 54,60 étant réalisée par l'intermédiaire des joints 70 et de la cloison extérieure 48. La cloison 48 constitue une séparation d'une zone interne étanche, dans laquelle s'étendent les côtés 36,38 de la cornière 34 sur lesquels peuvent être fixées les traverses ou autres rails de support de l'appareillage. Du côté externe de la cloison 48 s'étend une zone non étanche servant de fixation aux pièces intermédiaires 74,78 avec leurs accessoires, tels que la charnière 80 ou les vis de fixation 72. En faisant porter les joints élastiques 70 sur les arêtes 44,46 on obtient une déformation suffisante pour compenser les irrégularités du profil ou autres déformations des éléments de structure de l'armoire. L'écrasement des joints 70 lors du serrage des vis 72 limite l'intervalle entre les panneaux 54 à 64 et les replis 40,42 et réduit les risques de pénétration d'eau et de mouillage des joints 70. Ce risque est de plus amoindri par les rebords 66 des panneaux 54 à 64 qui coiffent les extrémités des replis 40,42 en formant un véritable joint à labyrinthe limitant les risques de pénétration d'eau vers les joints 70. La forme du profilé permet par ailleurs d'assurer l'étanchéité soit avec un joint collé ou clipsé sur les replis 40,42, soit avec un joint collé ou clipsé à l'intérieur des panneaux constituant l'habillage. L'étanchéité des profilés formant des traverses horizontales peut être réalisée de la même manière en faisant coopérer les joints 70 avec les arêtes 44,46 mais selon un mode de mise en oeuvre préféré de l'invention, représenté à la figure 3, le joint 70 au-dessus de la porte 56 ou avantageusement tous les joints 70, intercalés entre les panneaux verticaux 54,56,58,60 et les profilés supérieurs horizontaux 18,20,22,24, sont légèrement décalés vers le haut de manière à coopérer avec la tranche 84 des replis 40,42. Il est facile de voir que ce décalage évite toute accumulation d'eau entre les panneaux et les replis 40,42 susceptibles d'affecter l'étanchéité de l'armoire ou de provoquer une pénétration d'eau lors de l'ouverture de la porte 56. Les profilés 10 à 32 sont assemblés à leurs extrémités par des pièces cubiques 86 ayant trois pieds orthogonaux s'emboîtant dans les extrémités triangulaires des profilés. Ces pièces sont rigoureusement identiques, quelle que soit leur position. Cet assemblage peut bien entendu être réalisé d'une autre manière, par exemple par soudage.

L'armoire selon l'invention est réalisée de la manière suivante:
Les profilés standards 10 à 32 de longueur appropriée, sont assemblés par des pièces cubiques 86 disposées aux angles de l'armoire en prenant soin d'orienter l'arête 68 des cornières vers l'intérieur de l'armoire. La parfaite symétrie des profilés évite toute erreur de montage et il est possible de réaliser toute une gamme d'armoire, soit en découpant les profilés à la demande, soit en prévoyant un stock de profilés de longueur différente, notamment avec une modularité de 25 mm dans les trois dimensions. Les profilés 10 à 32 assemblés, constituent une ossature ou charpente solide servant de fixation aux panneaux d'habillage 54 à 64 ainsi qu'aux traverses 53 ou rails de support des appareils logés à l'intérieur de l'armoire. Les panneaux 54 à 64 de dimensions appropriées sont ensuite fixés sur les différentes faces de l'armoire en prenant soin d'interposer les joints 70 entre les profilés et les bords des panneaux. Par vissage des vis 72 sur les pièces intermédiaires 74, préalablement fixées sur les cloisons extérieures 48, il est possible de serrer fortement les panneaux avec un écrasement des joints 70 en appui contre les arêtes 44,46 ou les tranches 84 des replis 40,42. La porte 56 est bien entendu fixée par la charnière 80 portée par la pièce intermédiaire 78, et une serrure (non représentée) est disposée sur le bord opposé de la porte 56 d'une manière bien connue des spécialistes. L'appareillage peut bien entendu être mis en place dans l'armoire avant la fixation de tous ou de certains panneaux 54 à 64. Le démontage des panneaux ou de l'armoire est extrêmement simple et il est possible d'accoler plusieurs ossatures les unes aux autres aussi bien latéralement, en profondeur ou en hauteur en maintenant l'étanchéité et en conservant les mêmes panneaux extérieurs.

Les profilés 10 à 32 peuvent être réalisés par tout moyen approprié, par exemple par extrusion, mais selon un procédé préférentiel, ils sont obtenus par pliage d'une bande de tôle, par exemple sur une machine automatique de galetage. La figure 4 représente un mode de réalisation à six pliages, les bords de la bande repliée étant agrafés au niveau du repli 40, qui présente trois épaisseurs de tôles superposées. On obtient ainsi des arêtes arrondies susceptibles de coopérer avec les joints d'étanchéité 70 sans risque de détérioration. Le repli opposé 42 est constitué par un simple repli et de ce fait de deux épaisseurs de tôles. La symétrie peut être conservée en ménageant un espace vide 86 entre les parties repliées pour conférer à ce repli 42 une épaisseur comparable ou égale à celle du repli 40 à trois épaisseurs. La figure 5 illustre une variante de réalisation dans laquelle l'épaisseur du repli 42 est accrue par l'insertion d'une cale 88 remplaçant le vide 86 entre les bords repliés du repli 42.

En se référant à la figure 6, on voit une autre variante de réalisation dans laquelle le profilé présente une aile 90 qui s'étend le long de l'arête 68 de la cornière 34, en saillie vers l'intérieur de l'armoire. L'aile 90 comporte des perforations 92 pour la fixation d'éléments internes de l'armoire. L'aile 90 s'étend dans le plan bissecteur de la cornière (figure 6) et elle est constituée par un repli de la tôle de la manière représentée sur la figure.

La structure selon l'invention confère au profilé une grande rigidité par rapport au poids et assure une étanchéité tout en conservant le gabarit externe de l'armoire permettant une juxtaposition aisée de plusieurs ossatures.

Les écrous des boulons de fixation aux profilés 10-32 doivent être introduits à l'intérieur de ces profilés et maintenus en regard de la perforation 52 recevant la vis. Sur la figure 2, on voit un support 94 commun à deux écrous 96, 98 venant en face de deux perforations 52 situées à un même niveau sur les deux ailes de la cornière. L'écrou 98 est monté à pivotement et à coulissement sur le support 94 pour permettre, à partir de la position active, représentée à la figure 4, un coulissement vers le bas et un pivotement pour mettre sur la tranche l'écrou rectangulaire autorisant le retrait par la perforation 52.

La figure 4 représente un écrou 100 monté dans une cage 102 en forme d'étrier. Le profilé 10-32 comporte sur l'arête 68 des perforations 104 au pas et au niveau des perforations 52 des côtés 36, 38 pour permettre une introduction de l'écrou 100 à l'intérieur du profilé en étant retenu par l'étrier 102 qui chevauche le côté. On voit sur la figure un écrou en place sur l'un des côtés 38 en regard de la perforation 52 et un autre écrou en cours d'insertion pour venir en face de la perforation 52 de l'autre côté 36. La cage 102 en acier plié présente un ergot 106, qui sous l'effort de serrage s'incruste dans le profilé pour assurer la continuité électrique. Une patte repliée 108 s'emboîte dans la perforation 52 pour centrer l'écrou.

## Revendications

1. Armoire d'appareillage électrique ou électronique ayant des parois formées par des panneaux (54-64) ou plaques fixés sur des éléments allongés (10-32) disposés aux angles de l'armoire et assemblés à leurs extrémités pour constituer une ossature de support, l'ensemble desdits éléments angulaires étant constitués par des profilés (10-32) tubulaires identiques disposés de la même manière et ayant deux faces orthogonales (36,38), orientées vers l'intérieur de l'armoire et munies de rangées de perforations (52) pour la fixation de traverses (53) de support de l'appareillage logé à l'intérieur de l'armoire, dont la continuité de l'étanchéité au niveau des jonctions angulaires des panneaux (54,64) est assurée par le profilé (10-32) correspondant, auquel sont accolés les bords espacés des panneaux avec interposition d'un joint d'étanchéité (70), le profilé (10-32) étant constitué par une cornière (34) dont les deux côtés (36,38) sont disposés à l'intérieur de l'armoire pour former lesdites deux faces orthogonales de fixation, le bord longitudinal de chaque côté (36,38), opposé à l'arête (68) de la cornière (34), étant replié en équerre vers l'intérieur suivant un contour tronqué contre lequel repli (40,42) est accolé le bord du panneau conjugué et le profilé présentant une cloison extérieure (48) reliant lesdits bords de la cornière et assurant l'étanchéité de la jonction angulaire en formant un prisme dont la base est un triangle rectangle isocèle, le profilé ayant un plan de symétrie correspondant au plan bissecteur de la cornière (34).

2. Armoire selon la revendication 1, caractérisée en ce que ledit joint d'étanchéité (70) en forme de bourrelet élastique coopère avec une arête (44,46,84) dudit repli (40,42) qui offre une surface de portée réduite assurant la pression de serrage et l'étanchéité.

3. Armoire selon la revendication 1 ou 2, caractérisée en ce que l'étanchéité sur les profilés (10-32) verticaux est assurée par un joint (70) en forme de bourrelet qui coopère avec l'arête (44,46) de pliage du bord de la cornière pour former ledit repli.

4. Armoire selon la revendication 1,2 ou 3, caractérisée en ce que l'étanchéité des panneaux verticaux (54-60) sur les profilés horizontaux (18,24) disposés à la partie supérieure de l'armoire est assurée par un joint (70) coopérant avec la tranche (84) libre dudit repli (40,42).

5. Armoire selon la revendication 1,2,3 ou 4, caractérisée en ce que ledit profilé (10-32) est constitué par une bande de tôle pliée dont les extrémités sont solidarisées par agrafage pour obtenir une ferme générale triangulaire et que lesdits joints d'étanchéité (70) coopèrent avec des arêtes arrondies (44,46,84) du profilé résultant du pliage de la tôle.

6. Armoire selon la revendication 5, caractérisée en ce que chaque repli (40,42) est constitué d'au moins deux épaisseurs de tôle.

7. Armoire selon la revendication 6, caractérisée en ce que ledit agrafage est réalisé au niveau de l'un (40) desdits replis qui présente trois épaisseurs de tôle, l'autre (42) desdits replis présentant une épaisseur comparable par insertion d'une cale (88) ou d'un vide (86) entre les deux épaisseurs de tôles.

8. Armoire selon l'une quelconque des revendications précédentes, caractérisée en ce que les rebords (66) dudit panneau (54-64) sont rabattus à angle droit pour rigidifier le panneau et que en position fixée du panneau sur le profilé, les parties rabattues pénètrent à l'intérieur dudit contour tronqué pour constituer avec le repli (40,42) conjugué du profilé un joint à labyrinthe.

9. Armoire selon l'une quelconque des revendications précédentes, caractérisée en ce qu'elle comporte des pièces intermédiaires (74,78) de fixation susceptibles d'être fixées à la cloison externe (48) du profilé (10-32) en s'inscrivant à l'intérieur dudit contour et de recevoir les vis (72) de fixation desdits panneaux (54-64) et/ou des charnières (80) d'une porte (56).

10. Armoire selon l'une quelconque des revendications précédentes, caractérisée en ce que le profilé (10-32) présente une aile (90) s'étendant dans le plan bissecteur de la cornière, le long de l'arête (68) de la cornière (34) en saillie vers l'intérieur de l'armoire pour la fixation d'éléments.

11. Armoire selon l'une quelconque des revendications précédentes, caractérisé en ce que le profilé (10-32) présente sur l'arête (68) une rangée de perforations (104) au niveau et au pas des perforations (52) sur les côtés (36, 38) pour l'insertion d'un écrou (100) à cage (102) à l'intérieur du profilé.

## Patentansprüche

1. Schaltschrank für elektrische oder elektronische Einrichtungen mit Außenwänden in Form von Abschlußblechen (54 bis 64) oder Platten, die auf entlang der Kanten des Schranks angeordneten und an ihren Enden zu einem Traggerüst miteinander verbundenen Rahmenelementen ( 10 bis 32) befestigt sind, wobei die genannten Rahmenelemente aus gleichen, einheitlich montierten Rohrprofilen (10 bis 32) mit zwei rechtwinkling zueinander stehenden Schenkeln (36, 38) bestehen, die zum Innenraum des Schranks hin ausgerichtet und mit zwei Reihen von Bohrungen (52) versehen sind zur Befestigung von Querstützen (53) für die Aufnahme der Schaltgeräte im Schrank, dessen fortlaufende Dichtigkeit im Bereich der Eckverbindungen der Abschlußbleche (54 bis 64) durch das jeweilige Rohrprofil (10 bis 32) gewährleistet wird, an dem die in Abstand liegenden Ränder der Abschlußbleche mit Zwischenfügung einer Dichtung (70) befestigt werden, wobei die Profile (10 bis 32) aus einem Winkeleisen (34) bestehen, dessen beide Schenkel (36, 38) im Innenraum des Schranks zur Bildung der genannten, rechtwinklig zueinander stehenden Befestigungsflächen angeordnet sind, die Längskante jedes, der Eckkante (68) des Winkeleisens (34) gegenüberliegenden Schenkels (36, 38) rechtwinklig gemäss einem abgeschnittenen Umriss nach innen gebogen ist, die jeweilige Abschlussblechkante gegen die umgebogene Zunge (40, 42) anliegt, und wobei das Profil eine äussere Trennwand (48) aufweist, welche die genannten Schenkelränder des Winkeleisens verbindet und die Dichtigkeit der Eckverbindung gewährleistet durch Bildung eines rechtwinkligen gleichschenkligen Dreieckprismas, wobei das Profil eine symmetrische Form hat, die der Winkelhalbierenden des Winkeleisens (34) entspricht.

2. Schaltschrank nach Anspruch 1, dadurch gekennzeichnet, daß die als elastische Wulst ausgeführte genannte Dichtung (70) mit einer Biegekante (44, 46, 84) der genannten Biegezunge (40, 42) zusammenwirkt, die eine verkleinerte Auflagefläche bietet und so den Anziehdruck sowie die Dichtigkeit gewährleistet.

3. Schaltschrank nach Anspruch 1 oder 2, dadurch gekennzeichnet, daß die Dichtigkeit an den senkrechten Profilen (10 bis 32) durch eine Dichtung (70) in Form einer Wulst gewährleistet wird, die mit der Biegekante (44, 46) des Winkeleisenrandes zusammenwirkt, um die genannte Biegezunge zu bilden.

4. Schaltschrank nach Anspruch 1, 2 oder 3, dadurch gekennzeichnet, daß die Dichtigkeit der senkrechten Abschlußbleche (54 bis 60) auf den an der Schrankoberseite montierten horizontalen Querprofilen ( 18, 24) durch eine Dichtung (70) gewährleistet wird, die mit dem freien Abschnitt (84) der genannten Biegezunge (40, 42) zusammenwirkt.

5. Schaltschrank nach Anspruch 1, 2, 3 oder 4, dadurch gekennzeichnet, daß das genannte Profil (10 bis 32) aus einem gebogenen Blechstreifen besteht, dessen Enden durch Falzen miteinander verbunden sind, im eine allgemeine dreieckige Form zu erhalten, und daß die genannten Dichtungen (70) mit den abgerundeten Kanten (44, 46, 84) des aus dem Blech gebogenen Profils zusammenwirken.

6. Schaltschrank nach Anspruch 5, dadurch gekennzeichnet, daß jede Biegezunge (40, 42) mindestens aus zwei Blechlagen besteht.

7. Schaltschrank nach Anspruch 6, dadurch gekennzeichnet, daß die genannte Falzverbindung an einer (40) der genannten drei Blechlagen aufweisenden Biegezungen ausgeführt wird, während die andere (42) der genannten Biegezungen durch Einfügen eines Keils (88) oder Freilassen eines Zwischenraums (86) zwischen den zwei Blechlagen eine vergleichbare Dicke aufweist.

8. Schaltschrank nach einem der vorhergehenden Ansprüche, dadurch gekennzeichnet, daß die Ränder (66) der genannten Abschlußbleche (54 bis 64) rechtwinklig abgeknickt sind, um dem Blech eine größere Steifigkeit zu verleihen, und daß die abgeknickten Ränder nach dem Anbringen des Abschlußbleches auf dem Profil ins Innere des genannten abgeschnittenen Umrisses eindringen, um zusammen mit der jeweiligen Biegezunge (40, 42) des Profils eine Labyrinthdichtung zu bilden.

9. Schaltschrank nach einem der vorhergehenden Ansprüche, dadurch gekennzeichnet, daß er Befestigungs-Zwischenstücke (74, 78) aufweist, die auf der äusseren Trennwand (48) des Profils (10 bis 32), im Innern des genannten Umrisses, befestigt werden können und Schrauben (72) zur Befestigung der genannten Abschlußbleche (54 bis 64) und/oder der Scharniere (80) einer Tür (56) aufnehmen können.

10. Schaltschrank nach einem der vorhergehenden Ansprüche, dadurch gekennzeichnet, daß das Profil (10 bis 32) eine Verlängerung (90) aufweist, die sich in der Ebene der Winkelhalbierenden des Winkeleisens, längs der Eckkante (68) des Winkeleisens (34) erstreckt, und in den Innenraum des Schaltschranks hineinragt zur Befestigung von Elementen.

11. Schaltschrank nach einem der vorhergehenden Ansprüche, dadurch gekennzeichnet, daß das Profil (10 bis 32) auf der Eckkante (68) eine Reihe von Aussparungen (104) aufweist, die mit gleichen Abständen und in gleicher Höhe wie die Bohrungen (52) der Schenkel (36, 38) angeordnet sind, für die Einführung einer Mutter (100) mit Käfig (102) ins Innere des Profils.

## Claims

1. An electrical or electronic switchgear cabinet having walls formed by panels (54-64) or plates affixed to lengthwise parts (10-32) located at the corners of the cabinet and assembled at their ends to constitute a support framework, the set of said angular parts being formed by identical tubular frame sections (10-32) arranged in the same way and having two orthogonal faces (36, 38), facing the inside of the cabinet and provided with rows of holes (52) for securing transverse support struts (53) of the switchgear housed inside the cabinet, whose continuity of sealing at the level of the angular junctions of the panels (54, 64) is ensured by the corresponding frame section (10-32), to which the spaced apart edges of the panels are adjoined with a seal (70) fitted in between, the frame section (10-32) being formed by a corner-piece (34) both sides (36, 38) of which are disposed inside the cabinet to form said two orthogonal fixing faces, the longitudinal edge of each side (36, 38), opposite the apex (68) of the corner-piece (34) being folded inwards into a bracket with a truncated profile against which folded end (40, 42) the edge of the conjugate panel is pressed and the frame section having an external partition (48) joining said edges of the corner-piece (34) and providing sealing of the angular junction by forming a prism whose base is an isoceles right-angle triangle, the frame section having a symmetry plane corresponding to the plane bisecting the corner-piece (34).

2. The cabinet according to claim 1, characterized in that said seal (70) in the form of an elastic cushion cooperates with an edge (44, 46, 84) of said folded end (40, 42) which offers a reduced bearing surface ensuring clamping pressure and tight sealing.

3. The cabinet according to claim 1 or 2, characterized in that sealing on the vertical frame sections (10-32) is performed by a seal (70) in the form of a cushion which cooperates with the folded apex (44, 46) of the edge of the corner-piece to form said folded end.

4. The cabinet according to claim 1, 2 or 3, characterized in that sealing of the vertical panels (54-60) on the horizontal frame sections (18, 24) located in the upper part of the cabinet is performed by a seal (70) cooperating with the free edge (84) of said folded end (40, 42).

5. The cabinet according to claim 1, 2, 3 or 4, characterized in that said frame section (10-32) is formed by a folded sheet metal strip whose ends are securedly united by clamping to obtain a general triangular shape and that said seals (70) cooperate with rounded edges (44, 46, 84) of the frame section resulting from folding of the sheet metal.

6. The cabinet according to claim 5, characterized in that each folded end (40, 42) is made up of at least two thicknesses of sheet metal.

7. The cabinet according to claim 6, characterized in that said clamping is performed at the level of one (40) of said folded ends which has three thicknesses of sheet metal, the other (42) of said folded ends having a comparable thickness by insertion of a shim (88) or a gap (86) between the two thicknesses of sheet metal.

8. The cabinet according to any one of the above claims, characterized in that the edges (66) of said panel (54-64) are folded at right angles to give the plate rigidity and that in the affixed position of the panel on the frame section, the folded parts penetrate into said truncated profile to form a labyrinth seal with the conjugate folded end (40, 42) of the frame section.

9. The cabinet according to any one of the above claims, characterized in that it comprises intermediate fixing parts (74, 78) designed to be fixed to the external partition (48) of the frame section (10-32) being inscribed within said profile and to receive the fixing screws (72) of said panels (54-64) and/or of the hinges (80) of a door (56).

10. The cabinet according to any one of the above claims, characterized in that the frame section (10-32) has a wing (90) extending in the plane bisecting the corner-piece (34) along the edge (68) of the corner-piece (34) and protruding inwards into the cabinet for fixing of components.

11. The cabinet according to any one of the above claims, characterized in that the frame section (10-32) has on the edge (68) a row of holes (104) at the level and pitch of the holes (52) on the sides (36, 38) for insertion of a nut (100) with a cage (102) inside the frame section.
